# FASCICULE DE BREVET EUROPEEN

(11) **EP 1 603 145 B1**
(45) Date de publication et mention de la délivrance du brevet: **08.07.2015**
(21) Numéro de dépôt: 05360012.8
(22) Date de dépôt: 18.03.2005
(51) Int. Cl.: H05K 1/11, H01H 1/16

(54) **Dispositif de liaison électrique**
Vorrichtung für das Herstellen einer elektrischen Verbindung
Device for making an electric connection

(30) Priorité: 26.03.2004 FR 0403198
(43) Date de publication de la demande: 07.12.2005
(73) Titulaire: Delphi Technologies Inc., Troy, MI 48007 (US)
(72) Inventeur: Ritondo, Cédric, 67200 Strasbourg (FR); Bamik, Mohamed, 67300 Schiltigheim (FR)
(74) Mandataire: Delphi France SAS

(56) Documents cités:
- DE-A- 1 690 181
- GB-A- 1 093 067
- US-A- 3 229 053
- US-A- 3 293 399
- US-A- 5 826 706

## Description

La présente invention se rapporte au domaine technique des connexions électriques et plus particulièrement au domaine des contacts électriques. Ces derniers sont par exemple réalisés avec deux pièces conductrices en mouvement relatif l'une par rapport à l'autre. Ce genre de liaison électrique est rencontrée notamment dans des commandes de colonnes de direction de véhicules automobiles.

L'obtention d'un bon contact électrique entre deux pièces conductrices en mouvement relatif l'une par rapport à l'autre, repose sur un compromis entre une pression de contact suffisante entre lesdits pièces et une faible usure lors du déplacement relatif desdites pièces.

On est donc amené à rechercher à la fois une usure minimale tout en n'altérant pas le contact entre les pièces conductrices en mouvement rotatif. Afin d'avoir une usure minimale il est préférable d'utiliser un contact ponctuel.

On connaît par exemple une pièce conductrice fixe, sensiblement plane, et une pièce conductrice mobile de forme circulaire se déplaçant sur la dite pièce fixe afin d'obtenir ce contact sensiblement ponctuel.

On connaît par exemple un circuit imprimé comportant un support en matière isolante et des pistes conductrices sous forme de dépôts métalliques sur le support, au moins deux pistes conductrices étant séparées l'une de l'autre par une zone isolante du support.

On utilise ce type de circuit imprimé en tant que pièce conductrice fixe sur laquelle se déplace par exemple un rouleau conducteur monté sur ressort ou tout autre contact mobile, du type lame flexible.

On connaît également un dispositif de liaison électrique comportant deux pièces conductrices en mouvement relatif l'une par rapport à l'autre, l'une des pièces conductrices étant un circuit imprimé présenté ci-dessus et l'autre pièce conductrice étant un organe mobile de contact électrique se déplaçant par rapport au circuit imprimé suivant un trajet s'étendant sur au moins deux pistes conductrices et sur au moins une zone isolante les séparant. L'organe mobile de contact électrique est appliqué contre le circuit imprimé par l'intermédiaire d'un moyen de rappel élastique.

GB-A-1093067 divulgue un rouleau de contact pour des commutateurs et des relais électriques

L'utilisation de ces dispositifs et de ces circuits imprimés génère très souvent lors des déplacements du contact électrique et plus particulièrement lors de son passage d'une piste à une autre des rebonds mécaniques pouvant altérer la liaison électrique ou tout simplement augmenter les points de contact électriques de manière à causer des court-circuits.

A titre d'exemple, lors de l'utilisation d'un rouleau conducteur monté sur ressort et se déplaçant d'une piste conductrice à une autre, on constate un déplacement dudit rouleau conducteur dans une direction orthogonale par rapport au plan d'extension des pistes conductrices.

L'organe mobile de contact électrique, en l'occurrence un rouleau conducteur, suit le relief du circuit imprimé lors de son déplacement. Deux pistes conductrices successives sont en effet séparées par une gorge dont la profondeur est déterminée par l'épaisseur desdites pistes conductrices. Lors de son déplacement, l'organe mobile de contact électrique ou le rouleau conducteur épouse le relief rencontré et prend appui sur le fond de cette gorge en passant d'une piste à une autre. Le rouleau conducteur s'engage donc au moins partiellement dans cette gorge.

Un déplacement rapide d'un rouleau conducteur peut alors provoquer avec son engagement dans la gorge séparant les pistes conductrices, des rebonds du rouleau conducteur. La fiabilité de la liaison électrique s'en trouve donc affectée.

En outre, il est indispensable de ménager un écart suffisant entre deux pistes conductrices successives afin que le rouleau conducteur une fois positionné au fond de la gorge ne réalise pas un court-circuit entre lesdites pistes conductrices successives. Ceci conduit à prévoir un écart suffisant entre les pistes conductrices successives et par conséquent à augmenter les dimensions et par conséquent l'encombrement du circuit imprimé. Ceci peut s'avérer problématique pour son montage dans des dispositifs ou dans des boîtiers présentant un espace disponible limité.

Il a été prévu de munir le circuit imprimé d'un organe d'appui s'étendant dans la zone isolante. L'organe d'appui est rapporté au support et présente sensiblement la même épaisseur que les pistes conductrices. On pourra se reporter notamment au document US - 3,293,399. L'utilisation d'un tel organe d'appui augmente la complexité et par conséquent les coûts de fabrication des circuits imprimés. Ces derniers présentent par ailleurs l'inconvénient d'être spécifiques pour chaque configuration ou dessin de pistes conductrices. Le ou les organes d'appui doivent en effet être disposés différemment dès que l'on passe dessin de pistes conductrices à un autre.

Le but de la présente invention vise donc à pallier aux inconvénients de l'état de la technique et à réaliser une liaison électrique entre des pièces conductrices en mouvement relatif l'une par rapport à l'autre, présentant d'une part un encombrement réduit et d'autre part une fiabilité accrue dans la liaison électrique.

Selon l'invention, l'organe d'appui est une nervure réalisée avec un dépôt métallique isolé électriquement des pistes conductrices. On obtient ainsi l'avantage de réaliser simultanément les pistes conductrices et les organes d'appui, sans étapes complémentaires dans le procédé de fabrication et sans utiliser un matériau additionnel.

La nervure est par exemple réalisée avec une extension d'une piste conductrice complémentaire, isolée électriquement par rapport aux pistes conductrices, lesquelles s'étendent de part et d'autre de la zone isolante.

La présente invention concerne également un dispositif de liaison électrique comportant deux pièces conductrices en contact et en mouvement relatif, l'une des pièces conductrices étant un circuit imprimé tel que présenté ci-dessus et l'autre pièce conductrice étant un organe mobile de contact électrique se déplaçant par rapport au circuit imprimé suivant un trajet s'étendant sur au moins deux pistes conductrices et sur au moins une zone isolante les séparant, l'organe mobile de contact électrique étant appliqué contre le circuit imprimé par l'intermédiaire d'un moyen de rappel élastique.

Selon un exemple de réalisation du dispositif conforme à l'invention, l'organe mobile de contact électrique est un rouleau conducteur.

Le moyen de rappel élastique est par exemple un ressort.

La présente invention concerne également un sous-ensemble électrique et/ou électronique destiné à être intégré dans un véhicule comportant un dispositif de liaison électrique tel que présenté ci-dessus.

D'autres caractéristiques et avantages ressortiront également de la description détaillée figurant ci-après, en référence aux dessins donnés à titre d'exemple non limitatif, dans lesquels :
- la figure 1 est une vue de dessus d'un exemple de réalisation d'un dispositif de liaison électrique conforme à l'invention ;
- la figure 2 est une vue en section transversale selon la ligne II-II de la figure 1.

Le circuit imprimé 1 comporte un support 2 en matière isolante et des pistes conductrices 3, 4, 5 sous forme de dépôt métallique sur le support 2. Au moins deux pistes conductrices 3 et 4 sont séparées l'une de l'autre par une zone isolante 6 du support 2. La réalisation de tels circuits imprimés est connue en tant que telle et ne sera pas décrite plus en détails ici.

Le circuit imprimé 1 comporte en outre un organe d'appui s'étendant dans la zone isolante 6. L'organe d'appui est solidaire du support 2 et présente la même épaisseur que les pistes conductrices 3 et 4.

Ainsi, un organe mobile de contact électrique se déplaçant et s'appuyant sur le circuit imprimé 1 appuie avec une pression déterminée successivement sur la piste conductrice 3, sur l'organe d'appui et enfin sur la piste conductrice 4. Ceci permet de réduire substantiellement, voir d'éliminer complètement, les rebonds engendrés par un déplacement suivant une direction orthogonale au plan d'extension du circuit imprimé 1 de l'organe mobile de contact électrique.

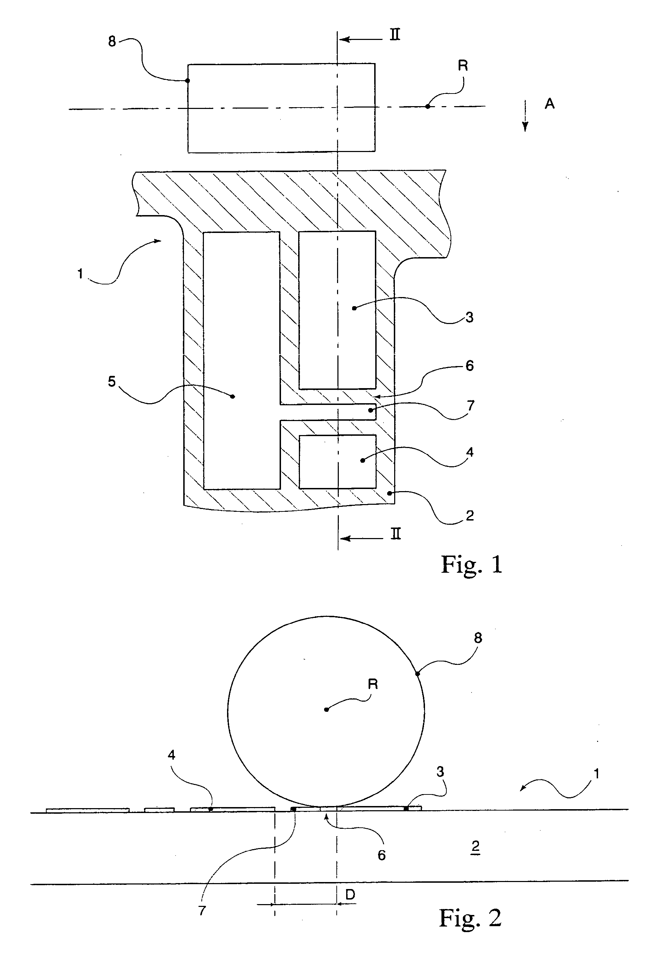

Ce dernier est par exemple constitué d'un rouleau conducteur 8 toumant autour d'un axe de rotation R lors de son déplacement. L'un des sens de déplacement du rouleau conducteur 8 est matérialisé par la flèche A à la figure 1.

L'organe d'appui est par exemple une nervure obtenue par dépôt métallique sur le matériau constitutif du support 2, lequel est obtenu par moulage. Le circuit imprimé 1 est alors un surmoulage constitué par une partie conductrice et une matière plastique par exemple PA (Polyamide), PBT (Poly Butylène Terephthalate) chargé ou non.

La nervure peut aussi être réalisée avec un matériau métallique rapporté sur le support 2 par exemple par collage. Il est aussi possible de déposer une pièce maintenue par soudure à l'étain ou de réaliser cette pièce par dépôt métallique isolé des pistes conductrices successives situées de part et d'autre de la zone isolante 6.

Selon un exemple de réalisation avantageux du circuit imprimé 1 conforme à l'invention, la nervure est réalisée avec une extension 7 d'une piste conductrice complémentaire 5 isolée des pistes conductrice 3 et 4 disposées de part et d'autre de la zone isolante 6. Une telle extension 7 est particulièrement avantageuse dans la mesure où elle simplifie les opérations de fabrication du circuit imprimé 1. En effet, aucune opération ou étape de fabrication supplémentaire n'est nécessaire pour la réalisation de l'organe d'appui.

L'invention concerne également un dispositif de liaison électrique comportant deux pièces conductrices en mouvement relatif l'une par rapport à l'autre, l'une des pièces conductrices étant le circuit imprimé 1 et l'autre pièce conductrice étant un organe mobile de contact électrique se déplaçant par rapport au circuit imprimé 1. Cet organe mobile de contact électrique se déplace suivant un trajet s'étendant sur au moins deux pistes conductrices 3, 4 et sur au moins une zone isolante 6 les séparant. Le contact électrique, en l'occurrence le rouleau conducteur 8, est appliqué contre le circuit imprimé 1 par l'intermédiaire d'un moyen de rappel élastique, non représenté. Ce dernier est par exemple constitué d'un ressort.

A titre variante, l'organe mobile de contact peut également être constitué de lames flexibles ou lames rigides maintenues en contact par un élément élastique type ressort.

Les pistes conductrices 3 et 4 successives présentent un écartement D schématisé par exemple à la figure 2. L'écartement D est inférieur à un écartement minimal obligatoire entre lesdites pistes conductrices 3 et 4 qui devrait être respecté en cas d'absence d'organe d'appui. L'absence d'un organe d'appui entre les pistes conductrices 3 et 4 conduirait à réaliser un pont électrique entre lesdites pistes lorsque le rouleau conducteur 8 s'engage dans la gorge définissant la zone isolante 6. Dans un tel cas, l'écartement D doit être choisi en tenant compte du diamètre du rouleau conducteur 8 et être augmenté. L'absence de déplacement ou le très faible déplacement du rouleau conducteur 8 suivant une direction orthogonale au plan d'extension du circuit imprimé 1, permet de conserver un écartement suffisant entre la piste conductrice 4 et le rouleau conducteur 8 lorsque ce dernier est encore en contact avec la piste conductrice 3. Un risque de court-circuit est ainsi évité. La présence de l'organe d'appui, en l'occurrence l'extension 7, permet ainsi de rapprocher substantiellement l'une de l'autre les pistes conductrices 3 et 4 et d'obtenir globalement une diminution des dimensions du circuit imprimé. Cet encombrement amélioré n'est en outre pas accompagné, grâce à l'invention, d'un risque accru de court-circuit entre les pistes conductrices 3 et 4.

## Revendications

1. Circuit imprimé (1) comportant un support (2) en matière isolante, des pistes conductrices (3, 4) sous forme de dépôts métalliques sur le support (2), au moins deux pistes conductrices (3, 4) étant séparées l'une de l'autre par une zone isolante (6) du support (2), un organe d'appui solidaire du support (2) et présentant sensiblement la même épaisseur que les pistes conductrices (3, 4, 5) s'étendant dans la zone isolante (6) **caractérisé en ce que** l'organe d'appui est une nervure réalisée avec un dépôt métallique isolé électriquement par rapport aux pistes conductrices (3,4).

2. Circuit imprimé selon la revendication 1, **caractérisé en ce que** la nervure est réalisée avec une extension (7) d'une piste conductrice complémentaire (5), isolée électriquement par rapport aux pistes conductrices (3, 4), lesquelles s'étendent de part et d'autre de la zone isolante (6).

3. Dispositif de liaison électrique comportant deux pièces conductrices en mouvement relatif l'une par rapport à l'autre, l'une des pièces conductrices étant un circuit imprimé (1) conforme à l'une quelconque des revendications 1 ou 2, et l'autre pièce conductrice étant un organe mobile de contact électrique, se déplaçant par rapport au circuit imprimé (1) suivant un trajet s'étendant sur au moins deux pistes conductrices (3, 4) et sur au moins une zone isolante (6) les séparant, l'organe mobile de contact électrique étant appliqué contre le circuit imprimé (1) par l'intermédiaire d'un moyen de rappel élastique.

4. Dispositif selon la revendication 3, **caractérisé en ce que** l'organe mobile de contact électrique est un rouleau conducteur (8).

5. Dispositif selon la revendication 4, **caractérisé en ce que** le moyen de rappel élastique est un ressort.

6. Sous-ensemble électrique et/ou électronique destiné à être intégré dans un véhicule, comportant un dispositif de liaison électrique conforme à l'une quelconque des revendications 3 à 5.

## Patentansprüche

1. Gedruckte Schaltung (1), enthaltend einen Träger (2) aus isolierendem Material, Leiterbahnen (3, 4) in Form von Metallablagerungen auf dem Träger (2), wobei zumindest zwei Leiterbahnen (3, 4) durch einen isolierenden Bereich (6) des Trägers (2) voneinander getrennt sind, wobei ein fest mit dem Träger (2) verbundenes Abstützglied mit im Wesentlichen der gleichen Dicke wie die Leiterbahnen (3, 4, 5) sich in dem isolierenden Bereich (6) erstreckt, **dadurch gekennzeichnet, dass** das Abstützglied eine Rippe ist, die mit einer Metallablagerung ausgebildet ist, die gegenüber den Leiterbahnen (3, 4) elektrisch isoliert ist.

2. Gedruckte Schaltung nach Anspruch 1, **dadurch gekennzeichnet, dass** die Rippe mit einer Erweiterung (7) einer zusätzlichen Leiterbahn (5) ausgebildet ist, die gegenüber den Leiterbahnen (3, 4) elektrisch isoliert ist, die sich beiderseits des isolierenden Bereichs (6) erstrecken.

3. Elektrische Verbindungsvorrichtung, enthaltend zwei leitfähige Teile, die sich relativ zueinander bewegen, wobei das eine leitfähige Teil eine gedruckte Schaltung (1) nach einem der Ansprüche 1 oder 2 ist und das andere leitfähige Teil ein bewegliches, elektrisches Kontaktglied ist, das sich bezüglich der gedruckten Schaltung (1) entlang einer Wegstrecke verlagert, die sich über zumindest zwei Leiterbahnen (3, 4) und über zumindest einen diese isolierenden Bereich (6) erstreckt, wobei das bewegliche, elektrische Kontaktglied über ein elastisches Rückstellmittel an die gedruckte Schaltung (1) angedrückt wird.

4. Vorrichtung nach Anspruch 3, **dadurch gekennzeichnet, dass** das bewegliche, elektrische Kontaktglied eine leitfähige Rolle (8) ist.

5. Vorrichtung nach Anspruch 4, **dadurch gekennzeichnet, dass** das elastische Rückstellmittel eine Feder ist.

6. Elektrische und/oder elektronische Unterbaugruppe, die dazu bestimmt ist, in ein Fahrzeug eingebaut zu werden, enthaltend eine elektrische Verbindungsvorrichtung nach einem der Ansprüche 3 bis 5.

## Claims

1. Printed circuit (1) including a support (2) made of insulating material, conductive tracks (3, 4) in the form of metallic depositions on the support (2), at least two conductive tracks (3, 4) being separated one from the other by an insulating zone (6) of the support (2), a bearing organ attached to the support (2) and having substantially the same thickness as the conductive tracks (3, 4, 5) extending in the insulating zone (6) **characterised by** the fact that the bearing organ is a rib made with a metallic deposition electrically insulated relative to the conductive tracks (3, 4).

2. Printed circuit as described in claim 1, **characterised by** the fact that the rib is formed with an extension (7) of an additional conductive track (5), electrically isolated relative to the conductive tracks (3, 4), which extend on either side of the insulating zone (6).

3. Electrical connection device including two conductive pieces in relative motion the one relative to the other, one of the conductive pieces being a printed circuit (1) in accordance with any one of claims 1 or 2, and the other conductive piece being a movable electrical contact organ, being displaced relative to the printed circuit (1) along a path extending over at least two conductive tracks (3, 4) and over at least one insulating zone (6) separating them, the movable electrical contact organ being applied against the printed circuit (1) using an elastic return means.

4. Device is described in claim 3, **characterised by** the fact that the movable electrical contact organ is a conductive roller (8).

5. Device as described in claim 4, **characterised by** the fact that the elastic return means is a spring.

6. Electrical and/or electronic subassembly intended to be integrated in a vehicle, including an electrical connection device in accordance with any one of claims 3 to 5.
